Europäisches Patentamt

European Patent Office

Office européen des brevets

(19)

(11) **EP 1 471 362 A1**

(12) **EUROPEAN PATENT APPLICATION**

(43) Date of publication:
**27.10.2004 Bulletin 2004/44**

(51) Int Cl.⁷: **G01R 33/28**

(21) Application number: **03076199.3**

(22) Date of filing: **24.04.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (72) Inventors:<br>• **Seppenwoolde, Jan Hendrik**<br>  **3524 JJ Utrecht (NL)**<br>• **Bakker, Christianus Johannes Gerardus**<br>  **3582 AS Utrecht (NL)** |
| (71) Applicants:<br>• **Universiteit Utrecht Holding B.V.**<br>  **3584 CK Utrecht (NL)**<br>• **UMC Utrecht Holding B.V.**<br>  **3584 CK Utrecht (NL)** | (74) Representative:<br>**Prins, Adrianus Willem, Mr. Ir. et al**<br>**Vereenigde,**<br>**Nieuwe Parklaan 97**<br>**2587 BN Den Haag (NL)** |

(54) **Selective MR imaging of magnetic susceptibility deviations**

(57)   Method for magnetic resonance imaging (MRI) of at least one specific element, wherein signal of background tissue represented in an MR image is at least partially dephased by applying a gradient imbalance or additional gradient, wherein signal around said element is accordingly conserved, resulting in a selective depiction of said element.

**EP 1 471 362 A1**

**Description**

The invention relates to a method for Magnetic Response Imaging (MRI), especially for selective depiction of susceptibility deviations.

In commonly known MR imaging, elements having a different magnetic susceptibility with respect to their background tissue, such as paramagnetic elements, will result as dark grey or black representations of said elements on, for example, interventional devices. This representation has poor contrast, especially when using relatively short imaging times, such as less than 20 seconds. This problem is even bigger in relatively thick imaging slices, the contrast being inversely proportional to the thickness of said slice. In common MRI circumstances this leads to poor visibility of said elements such as markers, necessitating the use of subtraction techniques using a reference image without the said elements. This is however very susceptible to respiration and to movements of for example a patient on which MR imaging is performed and this causes image information that obscures said elements such as markers. Moreover, this technique shall lead to time loss and the necessity of refreshing the reference image periodically.

The present invention has a main objective to provide a method for MR imaging resulting in selective imaging of devices and elements by providing positive contrast between background tissue and elements producing said local inhomogeneities such as paramagnetic markers.

A further objective is to provide for such a method in which said elements are selectively shown in said image as relatively light, whitish elements of representations thereof on a relatively dark, substantially gray or black background.

A still further objective is to provide for a method for MR imaging in which relatively short imaging times can be used, such that fast tracking is possible.

At least a number of these and further objectives is achieved with a method according to the present invention as defined by the features of claim 1.

By dephasing MRI signal from the background tissue, it has been seen shown that, surprisingly, the contrast between elements creating said field inhomogeneities and the background can be inverted and the said elements can be selectively depicted. This results in a better depiction of at least said elements or the representation thereof in said image. Even if relatively short imaging times and intervals are used, for example imaging times of less than 20 sec, more specifically less than 10 sec. Even imaging times of for example less than a second are possible with sufficient contrast.

It is preferred that an applied dephasing gradient is chosen such that the response around said element is changed from signal loss (dark gray or black representation) to signal conservation (whitish representation) and the response of the background is changed in reverse. Commonly known subtraction techniques can be used for further enhancing the depiction. Said images can be superposed on an image of the environment which image has not been treated according to the invention, said image being provided as a road map of the relevant environment.

The invention further relates to a method for passive tracking using MRI, as defined by claim 7.

The present invention furthermore relates to the use of a dephasing gradient in MR imaging as defined in claim 10 and to a method for inverting contrast and selective depiction as defined by the features of claim 12.

In the further claims various favorable embodiments of the invention are given.

In general terms it can be said that a method according to the present invention provides for the change of an ordinary "black marker" on an interventional MR imaging device to a "white marker" inverting the contrast. The appearance of the "white marker" can be controlled by an imbalance in applied imaging gradients, in either direction or an offset of the excitation pulses for MR imaging.

By removing said imbalance and/or said offset the "white marker" can be changed back to a "black marker" and vice versa. This can be advantageous in for example overlaying said images containing "white markers" on conventionally made (angiographic) 2D images containing no or "black markers" Also other methods for tracking can be combined with a method according to the present invention, such as an adjustable marker as disclosed by Glowinski [1], incorporated herein by reference.

For a better understanding embodiments of the present invention are described hereafter by way of examples, with reference to the drawing. This shows:

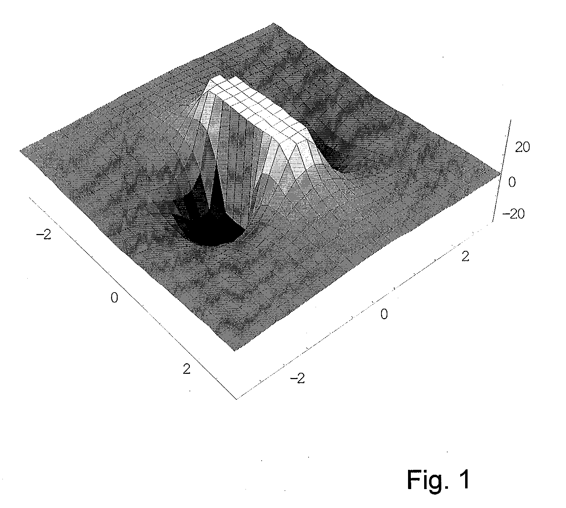

Figure 1: Plot of the dipole field inhomogeneity (Eq.2) of a single paramagnetic marker with $\Delta\chi V = 5.0\cdot10^{-4}$ mm$^3$ and $B_0 = 1.5$ T evaluated at x=0.5 mm, showing regions with positive and negative gradients. Plotted values range from -20 to 20 $\mu$T;

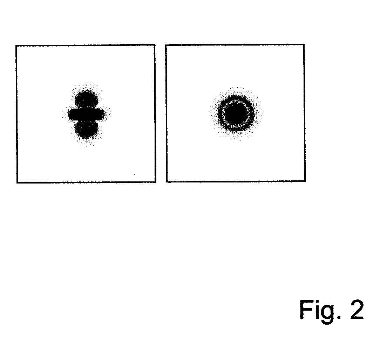

Figure 2: Evaluation of Eq. 3 for a coronal (left) and transversal (right) slice, showing the signal intensity pattern of typical susceptibility artifacts of a paramagnetic marker for conventional gradient echo imaging;

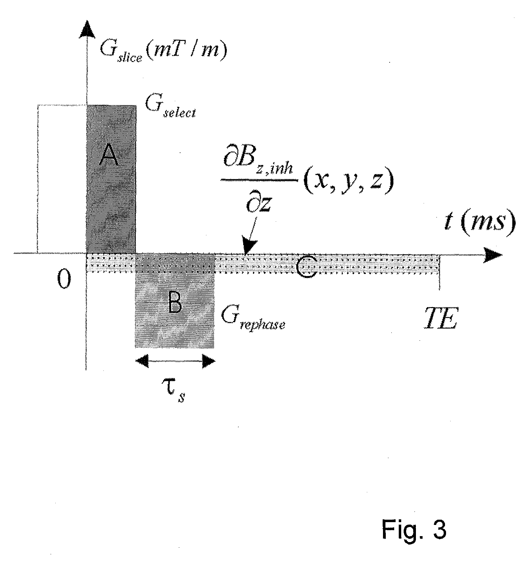

Figure 3: Schematic depiction of the concept of signal conservation for gradient areas in the slice selection direction. In general, after excitation at t=0 msec, the slice selection gradient $G_{select}$ dephases (area A) the spins. To rephase the excited spins, normally the full area B compensates for the slice selection area. Reducing area B creates a gradient imbalance, effectively resulting in a signal decrease. However, in spatial regions with a negative local gradient due to the dipole field (area C), the gradient balance is restored and signal remains conserved, whereas other regions will experience signal loss;

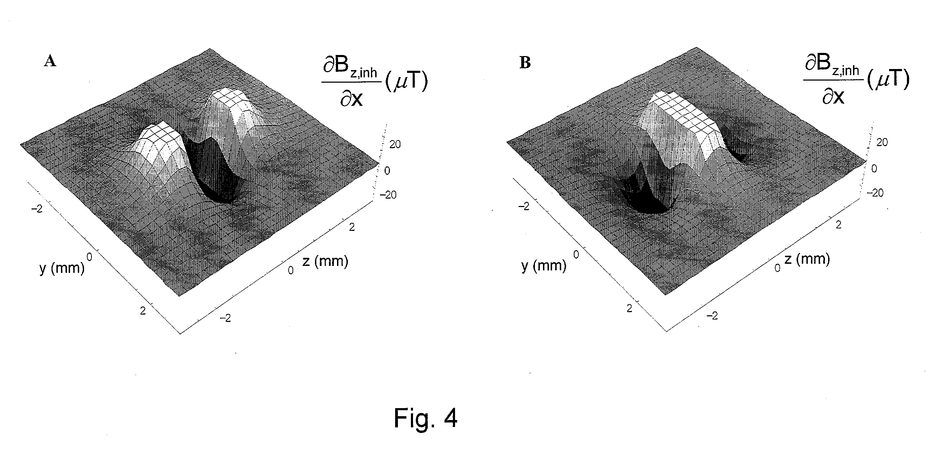

Figure 4: Plots of the derivatives of a dipole field distortion in the coronal plane for a marker with $\Delta\chi V = 5.0 \cdot 10^{-4}$ mm$^3$ and Bo = 1.5 T. Plotted values range from -20 to 20 µT. The derivatives are evaluated at x = 1 mm (a) and at x = -1 mm (b) and show a negative local gradient at respectively the centre and outer lobes of the dipole field. After addition of a positive background gradient these regions will show signal conservation;

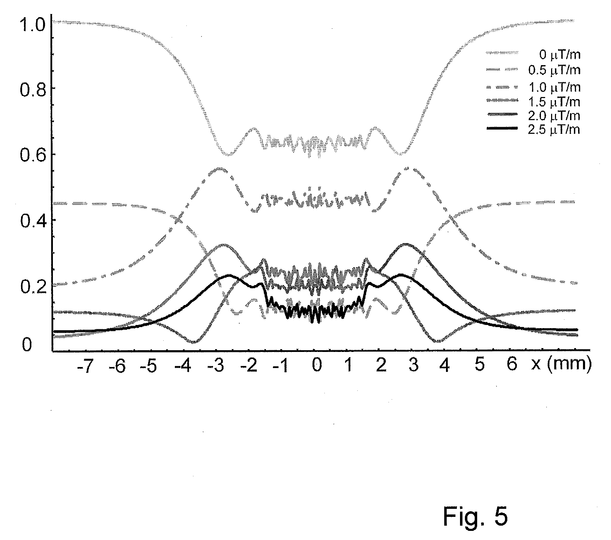

Figure 5: Plot of the calculation of normalized signal intensities (Eq.4) in a transversal plane (z=1 mm, y=0 mm) of a paramagnetic marker ($\Delta\chi V=5.0 \cdot 10^{-4}$mm$^3$) in a homogeneous background, showing the influence of variation of an additional gradient in slice direction, ranging from 0 to 2.5 µT/m. For a higher slice gradient, the background signal decreases and in the vicinity of the marker (at x=0 mm), signal is conserved. For this example (Slice 30 mm, TE 10 ms and B$_0$ 1.5 T), the contrast is inverted for $G_s$ = 1.0 µT/m.

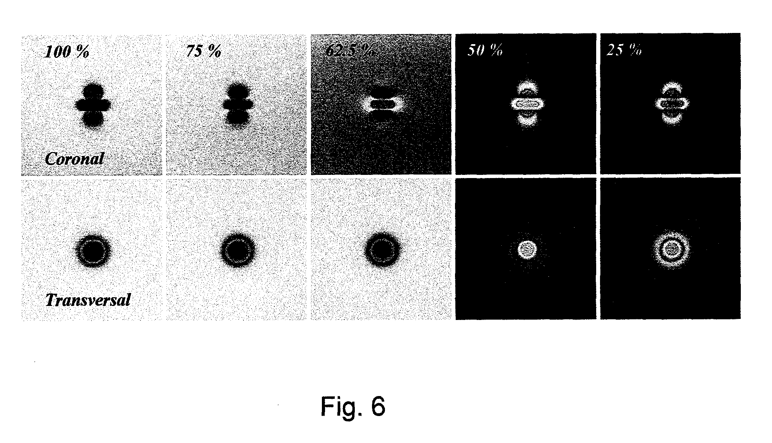

Figure 6: Experimental images (FOV 196×156 mm, matrix 512$^2$, 30 mm slice thickness, flip 30°, TR/TE 100/10 ms) of the transition from conventional to dephased positive contrast gradient echo imaging for a coronal (top row) and transversal slice (bottom row). The rephasing strength of area B in Fig. 3 is decreased from 100% to 25 %. Using 50% rephasing, a clear positive contrast is observed. Each image is scaled independently and is cropped to 25% of the FOV;

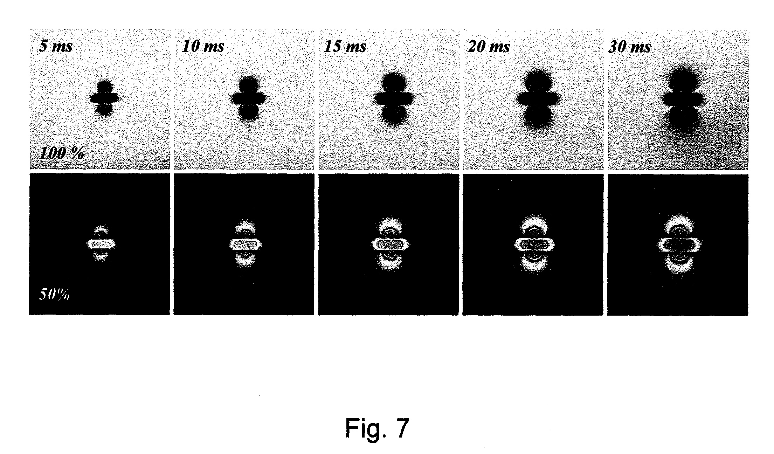

Figure 7: Experimental coronal images (FOV 196x156 mm, matrix 512$^2$, 30 mm slice thickness, flip 30°, TR 100 m) of the echo time dependence of conventional (100% rephasing, top row) and dephased, positive contrast (50% rephasing, bottom row) gradient echo imaging, showing the appearance of localized signal conservation with a typical dipole shape. The echo time is varied between 5 and 30 msec, showing an enlarging shape for both conventional and dephased imaging. The grey level of each image is scaled independently to its maximum and minimum value;

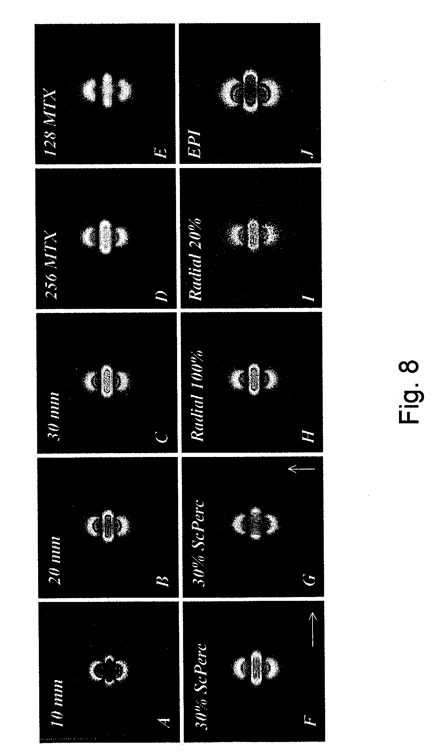

Figure 8: Experimental coronal images (196×156 mm, matrix 512$^2$, 30 mm slice thickness, TE 10 ms, flip 30°, TR 100 ms) showing the robustness of depiction of the positive contrast for 50% rephasing with variation of various acquisition parameters: variation of slice thickness from 10 to 30 mm (a-c), decreased matrix of 256 and 128 (d, e), reduced scan percentage of 30% (f,g) with readout directions as indicated by the small arrows, radial acquisition with 100% (h) and 20% (i) density of angles, and 11 readouts per excitation for TE = 25 ms (j).

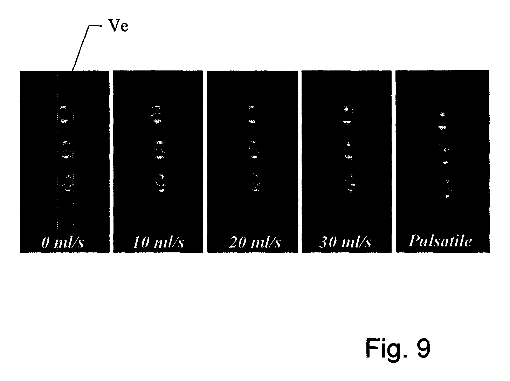

Figure 9: Experimental coronal images showing the influence of the variation of flow pattern on the shape of the white markers. The vessel (diameter 6 mm) is not visible in the images and is indicated by the dashed white line (Ve) in the left image. From left to right the flow is varied from 0 to 30 ml/s. The right image shows pulsatile flow with a peak of 100 ml/s and an average of 30 ml/s. Flow direction is from bottom to top;

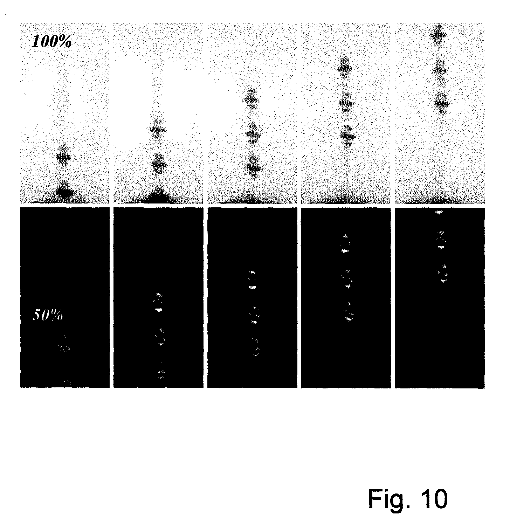

Figure 10: Experimental coronal images showing subsequent images of tracking for both the conventional (100% rephasing, top row) and the dephased (50% rephasing, bottom row) gradient echo imaging. The flow pattern for the bottom row was pulsatile with a peak of 100 ml/s and an average of 30 ml/s;

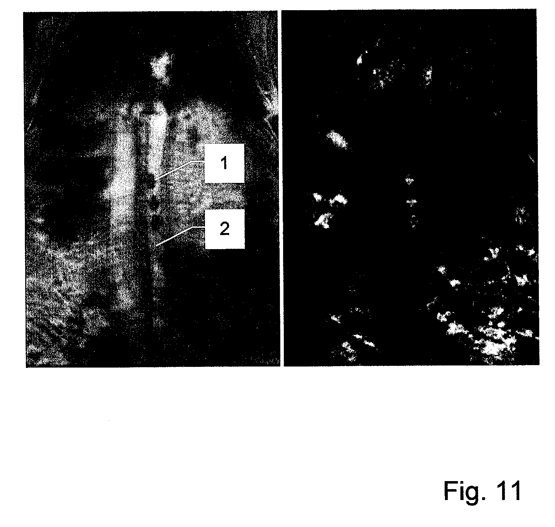

Figure 11: In vivo imaging of three paramagnetic markers (1), mounted on a 5-F catheter (2), located in the abdominal aorta of a living pig, as visualized with (a) conventional gradient echo sequence (FOV 350×245 mm, MTX256$^2$, slice thickness 30 mm, TE/TR=4.6/60 ms, flip=15°, 2 averages, duration 22 s) and (b) dephased positive contrast gradient echo imaging (white marker sequence with $G_{reph}$= 1.5 µT·s·m$^{-1}$) for similar acquisition parameters;

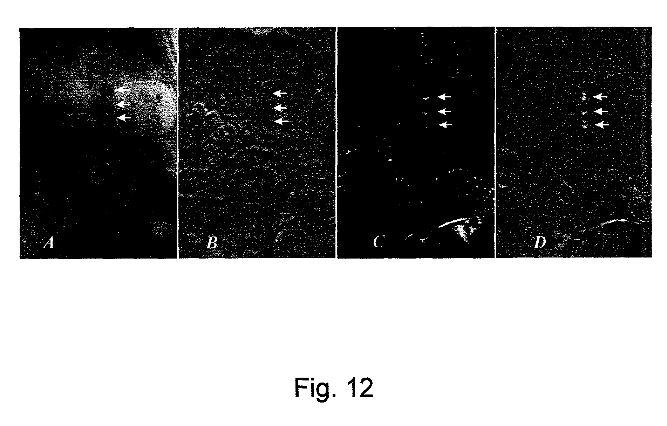

Figure 12: Demonstration of the performance of in vivo application of white marker tracking in the abdominal aorta of a living pig for a case with significant obscuring of the markers during dynamic tracking of the catheter. For (a) unsubtracted and (b) subtracted conventional tracking, the markers are hardly seen, whereas the white marker tracking allows easy detection of the markers for both (c) unsubtracted and (d) subtracted positive contrast tracking. Three separate paramagnetic markers (arrows) indicate the position of a 5F catheter;

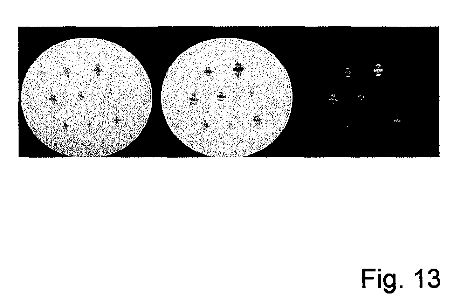

Figure 13: Comparison of conventional GE (a,b) and modified GE(c) to identify the presence and location of mesoscopic susceptibility artefacts: 1) Lead (135 mg), 2-5) Aluminium (respectively 14, 7, 4 and 2 mg), 6) Copper (39 mg), 7-8) plastic spheres. General acquisition parameters: FOV 128, MTX 256, slice 20 mm, TR 100, 30° flip;

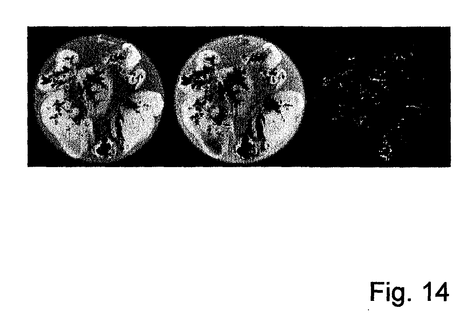

Figure 14; Comparison of conventional GE (a,b) and modified GE (c) to identify and located clusters of holmium-loaded microspheres. General acquisition parameters for both sequences: coronal, FOV 128 mm, MTX 128, slice 5.0 mm, TR 1800 ms, 90° flip;

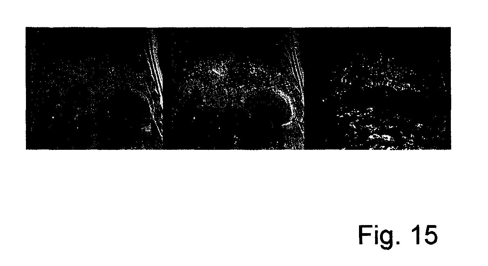

Figure 15; In vivo detection by conventional multi-echo GE (a,b) and modified GE (c) of clusters of paramagnetic microspheres after intra-arterial injection in the hepatic artery. Both sequences reveal the distinct presence of the microspheres in the liver and their absence in the spleen and stomach. Acquisition parameters: FOV 395, MTX 256, slice 7.0 mm, TR 500 ms, flip 90°; and

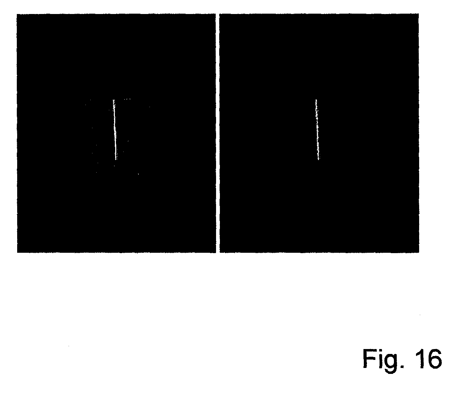

Figure 16; Experimental transversal images of an slightly paramagnetic needle (×= 1500 ppm, ∅ = 1 mm) immersed in a cylindrical cup. *(left)* transition to the selective depiction where background signal is partially dephased. (*Right*) selective depiction of the immersed needle, represented with positive contrast and significant suppression of background signal. Acquisition parameters are: FOV 256 mm.

It should be emphasised that the examples discussed hereafter, relating to in vitro and in vivo experiments of passive tracking of a catheter and a needle and of elements foreign to the human or animal body, such as holmium particles, metal particles and the like, are only shown and discussed in elucidation of the invention and should by no means be understood as limiting the scope of invention.

For a good understanding of the principle of the invention an introduction is given to the general concept and theory of local gradient compensation as used in the present invention for MRI imaging. Then examples are discussed of tracking a catheter and a needle and examples of locating elements, in vitro and in vivo.

**Introduction**

In endovascular interventional MRI, consistent and reliable tracking of the inserted devices is one of the major requirements for the success of an MR-guided endovascular intervention. In the past, several methods have been suggested and shown valuable. In the active approach, a combination of small catheter mounted receiver coils and readout-gradients along the coordinate axes can be used to determine the actual position of the coil (1). This method is very time efficient because only three readouts are needed for coil localization. However, a significant drawback of this active approach is the yet unsolved problem of unacceptable potential heating of long connecting signal cables (2).

Passive tracking is not subject to heating problems. In this approach, small paramagnetic rings are mounted as markers on catheters and guidewires (3). These paramagnetic rings produce local field distortions, which show up as areas of signal loss in gradient-echo (GE) imaging. A disadvantage of passive tracking is that it is image-based, resulting in a relatively time-consuming tracking scheme. Furthermore, this tracking method is often hampered by the need for subtraction due to weak negative contrast of the passive markers to their background, especially if thick imaging slices are used. This subtraction leads to an undesired increased sensitivity to motion and flow artifacts.

The passive tracking approach would significantly improve if the described disadvantages could be overcome. Therefore a novel approach is presented to passive tracking using positive contrast of the markers to their background, so called 'white marker tracking'. The positive contrast results from dephasing the background signal with a slice gradient, while near the marker signal is conserved because the dipole field induced by the marker compensates the dephasing gradient.

**Theory**

*Dipole field distortion and intra-voxel dephasing*

In the passive tracking approach of endovascular interventional MRI, small paramagnetic rings are mounted on catheters and guidewires. As a result of the difference in magnetic susceptibility with respect to the background tissue, the paramagnetic rings produce a local magnetic field inhomogeneity. This inhomogeneity causes field variations within voxels, which causes spins within voxels to precess at different frequencies, according to the Lamor equation. For gradient-echo sequences without refocusing RF pulses, the voxel signal will decay because of irreversible intra-voxel dephasing. For intra-voxel dephasing, the averaged voxel signal is given by

$$S_{voxel} = \frac{1}{V} \int_V \rho(r) \exp(-i\varphi) d^3r \quad \text{with} \quad \varphi = \gamma B_{z,inh}(x, y, z) TE \qquad [1]$$

where $\varphi$ is the additional phase resulting from an inhomogeneous magnetic field distortion $B_{z,inh}$ (T) in the z-direction. Here $\rho(r)$ is the spin density, V is the voxel volume ($mm^3$), TE is the echo time (ms) and $\gamma$ the gyromagnetic ratio ($42.576 \cdot 10^6$ MHz $T^{-1}$) for protons. For a small paramagnetic particle, the inhomogeneous part of the field distortion outside the particle is described by a dipole, as given by

$$B_{z,inh}(x, y, z) = c \frac{x^2 + y^2 - 2z^2}{(x^2 + y^2 + z^2)^{5/2}} \text{with } c = \frac{B_0 \Delta\chi V}{4\pi} \qquad [2]$$

where $B_0$ (T) is the main magnetic field, oriented along the z-axis and $\Delta\chi V$ ($mm^3$) characterizes the local magnetic dose [4] of the marker as the product of the difference of volume susceptibilities to the environment and the marker volume. The shape of the field distortion is illustrated in Figure 1, which shows areas of both positive and negative

$\Delta B_z$. In the case of thick imaging slices, signal loss owing to dephasing in the slice direction will be dominant. Integration of Eq. [1] over only the slice direction results in the normalized complex signal per voxel, as given by

$$S(x, y) = \frac{1}{d} \int_{-d/2}^{d/2} \rho(x, y, z) \exp(-i \gamma B_{z,inh}(x, y, z) \, TE) dz \qquad [3]$$

where p(x,y,z) is the actual signal producing spin density in three dimensions and d is the slice thickness (mm). In Figure 2, Eq. 3 is evaluated for a coronal and transversal slice with a thickness of 30 mm, a TE of 10 ms, and $\Delta_\chi V = 5.0 \cdot 10^{-4}$ mm$^3$, showing typical dipole susceptibility artifacts with negative contrast compared to their background.

*Dipole field distortion and dephasing in a background gradient*

If a background gradient is added in one direction, for example the z-direction, the local magnetic field experienced by the spins will change and consequently also the accumulated phase during acquisition. Inclusion of the additional phase resulting from the applied gradient changes Eq. 3 into

$$S(x, y) = \frac{1}{d} \int_{-d/2}^{d/2} \rho(x, y, z) \exp\left(-i \gamma \left(B_{z,inh}(x, y, z) TE + G_s \tau_s z\right)\right) dz \qquad [4]$$

where $G_s$ (mT/m) is the background gradient across the slice and τs (ms) the duration of this gradient. If the slice is regarded as summation of infinitesimal sub-slices (thickness dz), the phase φ for each sub-slice will be spatially dependent, as given by

$$\frac{\partial B_{z,inh}}{\partial z}(x,y,z) \, TE + G_s \tau_s \qquad [5]$$

In the case that this phase equals zero at TE, the effective dephasing is zero and signal is conserved. Figure 3 illustrates this concept of gradient compensation. For conventional gradient-echo imaging, area A and B equal each other, giving a normal gradient echo at the echo time. By reducing the strength of the rephasing lobe of the slice selection, a gradient imbalance is created, resulting in a signal decrease at the echo-time because spins are not fully rephased. However, in areas with local gradients due to a paramagnetic marker (area C), this imbalance can be cancelled, giving a full gradient echo in certain spatial regions. The local gradients are given by the derivatives of Eq.2, as calculated by

$$\frac{\partial B_{z,inh}}{\partial z}(x, y, z) = 3cz \, \frac{-3x^2 - 3y^2 + 2z^2}{(x^2 + y^2 + z^2)^{7/2}}, \quad \frac{\partial B_{z,inh}}{\partial x}(x, y, z) = -3cx \, \frac{x^2 + y^2 - 4z^2}{(x^2 + y^2 + z^2)^{7/2}} \qquad [6]$$

and are illustrated in Figure 4. Note that thanks to radial symmetry in Eq. 2, derivatives with respect to x and y show a similar spatial dependence. Because the derivatives vary spatially, different regions around the marker will cause the phase (as calculated with Eq. 5) to be zero, meaning local signal conservation at different spatial regions.

*Influence of acquisition parameters on the depiction of the white marker*

Because the signal conservation mechanism is based on canceling of dephasing, all acquisition parameters that influence dephasing are important in creating the white marker. Simulations readily show that slice thickness, background gradients and echo time are the most relevant parameters. In Figure 5, the influence of a background gradient on the signal intensity is given for a typical passive marker and tracking parameters. This figure shows that the transition from conventional to white-marker depiction is rather sudden and occurs for this specific example at 1.0 µT/m. In other cases, depending on the strength of the background signal, a higher or lower background gradient can be necessary to dephase the background signal sufficiently. Figure 5 also shows that for gradients higher than 1.5 µT/m, the extent of the conserved signal remains approximately the same. This is due to the shape of the dipole field distortion; for a higher applied gradient, a smaller radial distance to the marker would be sufficient for compensation. Furthermore, the figure shows that for higher gradients the absolute signal near the marker decreases, but the relative signal intensity to the background, i.e. the contrast, increases. For gradients higher than the maximum local gradients around the markers, it can be found that no further relevant gradient compensation will occur because no such high -and opposite - gradient exists around the passive marker. The dephasing gradient is therefore preferably chosen lower than the maximum gradient existing around the relevant element such as said marker.

**Example 1: Passive Tracking**

**Methods**

*In vitro experiments*

To experimentally examine the signal conservation around an individual dipole marker, as described in the theory section, a single $Dy_2O_3$-marker with $\Delta_\chi V$ of approximately $5.0 \cdot 10^{-4}$ mm$^3$ was suspended in the middle of a large cylindrical cup, filled with manganese-doped water as a background fluid. To mimic blood relaxation times, 19.2 mg $MnCl_2.4H_2O$ per liter was added, resulting in T1 = 1030 ms and T2 = 140 ms at 1.5 T. For imaging of the single paramagnetic marker, a 1.5 T system (Gyroscan Intera NT, Philips Medical Systems, Best, The Netherlands) was used. All images were acquired with a quadrature head receiver coil, acquisition parameters: FOV 196 $\times$ 156 mm, matrix (MTX) 512$^2$, TR 100 ms, flip angle 30°, slice thickness 30 mm, NSA 1. First a series of conventional gradient echo images was acquired using TE = 5, 10, 15, 20, 25, 30 ms. Then, for TE = 10 ms, the strength of the rephasing gradient (duration 7.49 ms) of the slice selection (Figure 3, area B) was changed from -0.178 mT/m to -0.133, -0.088, -0.044 and 0.00 mT/m in order to get 100, 75, 50, 25 and 0 % of the full rephasing area. In the regime where contrast inverts, the step size was decreased, yielding rephasing of 68.75, 62.50 and 56.25 %. This series was repeated for slices with a thickness of 20 and 10 mm and for a transversal slice with a thickness of 30 mm. For rephasing of 50 %, the same echo times were used as for the conventional gradient echo imaging, ranging from 5 to 30 ms. Finally, some individual acquisitions were made, in which parameters like scan matrix, scan percentage and number of readouts per excitation were varied, while other parameters remained constant as described above. The matrix size was decreased from 512 to 256 and 128. The scan percentage was decreased from 90 to 30 % for both readout gradient directions. For the acquisition with 11 readouts per excitation, the echo time was set to 25 ms, close to the minimal echo time. Furthermore, radial scanning was performed using radial coverage of 100 and 20 %.

For passive tracking experiments, three small paramagnetic ring-markers of the same strength of $5.0 \cdot 10^{-4}$ mm$^3$ were mounted on a 5-F catheter. The distance between the markers was 2 cm. To simulate blood flow conditions, a computer-controlled pump (CardioFlow 1000 MR, Shelley Ltd., North York, Ontario) filled with blood mimicking fluid was connected to a flow phantom. Inside the phantom, a thin walled cellulose tube (Dialysis tubing-Visking, Medicell Ltd., London, UK) with a diameter of 6 mm was used as a model for a vessel. The phantom was also filled with manganese-doped water. All images where made with the following parameters: FOV 256x204 mm, MTX 256$\times$204, slice thickness 30 mm, flip 10°, TR/TE = 12/5.6 ms. Duration of a single acquisition was set to 2.5 s to allow movement of the catheter in the pause between two acquisitions. After insertion of the catheter, the contrast between marker and background was changed using steps of 25%, until the contrast was satisfactory. Then, flow strength and pattern were varied, using constant flow of 0, 10, 20, 30 ml/s, and various forms of pulsatile flow (peak 60-100 ml/s, average 10-30 ml/s).

*In vivo experiments*

*In vivo* experiments were performed in two domestic pigs of respectively 84 and 91 kg under the approval of the animal care and use committee of Utrecht University. During the experiments, the pigs were under general anesthesia. A magnetically prepared 5-F catheter (Cordis Europa, Roden, The Netherlands) with three markers of $5.0 \cdot 10^{-4}$ mm$^3$ was introduced into the right femoral artery via a 9 Fr sheath and moved up and down in the abdominal aorta under dynamic MR imaging, using both conventional and positive contrast gradient echo imaging (with 50% rephasing). The acquisition parameters for the dynamic tracking sequence were: FOV 350x280 mm, MTX 153$\times$256, slice thickness 40 mm, flip 10°, TR/TE 8.8/4.3 ms, flow compensation in all directions resulting in a frame-rate of about 2 s per image. Once the catheter was present in the aorta, a two-dimensional single acquisition with higher signal-to-noise and resolution was preformed. Parameters were: FOV 350$\times$245 mm, MTX 256$^2$, slice thickness 30 mm, TR/TE 60/4.6 ms, flip 15°, duration 23 s. All slices were oriented coronally and covered the abdominal aorta, renal arteries and liver region. For both conventional and positive contrast tracking, subtraction from a baseline image was performed to enhance depiction of the markers.

**Results**

*In vitro experiments*

First, the depiction and contrast of an individual marker was studied *in vitro.* In Figure 6, the transition from conventional negative-contrast gradient echo imaging to positive-contrast 'white marker' imaging is depicted. The figure also shows that a decreased rephasing causes the background to dephase, while the signal is conserved in the vicinity of the dipole field distortion, as expected from theory. In this type of sequence, contrast is inverted at about 50 % rephasing. The rephasing area of the slice selection gradient remained constant at about -0.02 $\mu$T·s throughout variation of acquisition parameters, as calculated by the product of slice thickness, gradient strength and duration. This means that the area of signal conservation experienced a gradient of approximately 0.7 $\mu$T·s·m$^{-1}$. In this area of 50% rephasing, the background suppression was sufficient to observe conserved signal around the dipole field distortion. Transition from negative to positive contrast was quite sudden, as was also shown in the theoretical section. Although this is not visible in the independently scaled images, the absolute signal decreased with increasing dephasing.

Variation of the echo time influenced the size of the observed hyper-intensity, as depicted in Figure 7. The change in size for both conventional and dephased gradient echo imaging was approximately the same. The size of the white marker is a somewhat larger, because signal is conserved in regions with moderate gradients, which are too weak to cause complete dephasing in normal gradient echo imaging. The location of signal conservation shifted to regimes with lower dipole gradient fields if the echo time was increased. This corresponds to a stretched but constant area C in Figure 3.

Figure 8 shows that the mechanism of signal conservation is robust, indicating a reliable depiction of the marker for all types of different sequences. This robustness is present because the conservation mechanism in the slice direction can be thought of as a signal preparation mechanism, without influencing acquisition in read and phase direction. Therefore, actual visibility of a white marker for a given sequence is only a matter of signal-to-noise ratio. Note that in the case of a thin slice (10 mm), less signal is conserved near the marker and a ring-like pattern is observed (Figure 8a).

With respect to the influence of flow for *in vitro* tracking experiments, the markers showed only a slight deformation of their shape, as is shown in Figure 9. However, their size and center of mass were as good as identical. By using realistic flow conditions, it was still possible to track the markers with positive contrast (Figure 10). Here, the background was significantly suppressed. For comparison, conventional tracking is also shown.

*In vivo experiment*

After insertion of the catheter in the aorta of the pig, in vivo images of both conventional and positive contrast gradient echo were acquired (Figure 11). This figure shows that the paramagnetic markers could be visualized *in vivo* in a similar way as in the *in vitro* experiments: the white marker sequence clearly depicts the paramagnetic markers (and other sources of susceptibility artifacts) with positive contrast. *In vivo* tracking experiments showed that appearance of the marker for conventional tracking can be significantly obscured by thick imaging slices and subtraction artifacts owing to respiratory motion of the abdomen (Figure 12a), whereas depiction with the positive contrast sequence was straightforward, without the need for subtraction (Figure 12c). Additional subtraction of positive contrast tracking resulted in even better depiction, because background signal was significantly suppressed (Figure 12d). Since the white marker sequence is also sensitive to other local gradients, some residual signal resulting from other sources of susceptibility remained slightly visible, e.g. signal near the air-filled bowels and gadolinium-filled vessels (Figure 11, 12). However, during tracking experiments, this signal did not significantly hamper the localization of the markers on the catheter.

**Discussion**

The discussed embodiments of the invention relate to the selective depiction of paramagnetic markers by using local compensation of an applied slice gradient by the symmetrical dipole field distortion of the markers, while the same gradient dephases the background signal. The resultant positive contrast and signal conservation are the opposite of the negative contrast and signal loss in conventional gradient echo imaging. In practice, this contrast inversion and selective depiction of a paramagnetic marker only requires a small modification of the conventional passive tracking technique; a small gradient imbalance of a few $\mu$T·s would be enough.

The positive contrast mechanism was explained theoretically and shown experimentally for a symmetrical dipole field, but the compensation concept can be generalized to various types of field distortions, as long as a region of compensation exists. This means that it is also possible to selectively depict a slightly paramagnetic biopsy needle, as shown in figure 16, because a cylindrical object will show a dipolar field if it is not oriented parallel to the main magnetic field. A major advantage of using a spherical marker is the radially symmetrical nature of the field distortion around the z-axis, resulting in a similar - but with inverted contrast- marker appearance as in a conventional gradient echo sequence.

For thick imaging slices, the depiction of the white marker is rather invariant to changing the strength of the dephasing gradient; only a slight change in size will be observed because regions of signal conservation will shift towards higher or lower local gradients. The symmetrical nature of the field distortion is only observed if a dephasing gradient is applied in the slice direction, which happens to be the easiest way to apply such a gradient without influencing the acquisition. In other directions, the conservation mechanism will also be observed, but the actual observed shape will change since derivatives in the other directions are different. Because the mechanism of signal conservation can be considered as a signal preparation mechanism before the image acquisition, the positive contrast tracking, i.e. white marker sequence, is extremely robust in its signal behavior and can be applied to various types of imaging sequences.

Application of the signal conservation concept to tracking showed that the white marker sequence cancelled the need for subtraction thanks to selective depiction of paramagnetic markers and suppression of background signal. Because the described white marker sequence is sensitive to any local gradient, other sources of susceptibility will also give some residual signal. In practice, however, this residual signal did not hamper the tracking of the device in the dynamic images. Although not necessary to depict the markers, additional subtraction for the white marker sequence led to even better depiction of the white markers.

## Example 2: Selective depiction of paramagnetic elements

### Introduction

In conventional gradient echo (GE) imaging, small paramagnetic particles show up as signal voids, due to the intra-voxel dephasing induced by local field variation around the particles. It is often difficult to discern these signal voids from other low-intensity structures, especially if partial-volume effects in thick slices obscure the voids. Moreover, an inhomogeneous background can complicate the detection. From a radiological point of view, it would, therefore, be desirable to have a sequence that can be used to selectively detect mesoscopic (= subvoxel) paramagnetic particles. Such a sequence could, for instance, be used to identify microbleeds [5], small metal fragments [6] or small paramagnetic particles and clusters in T2*W gradient echo (GE) images.

### Methods

*Sequence*

It can be theoretically shown (see section: theory) that if conventional GE sequence is adapted by applying a background gradient in the slice direction, sources of susceptibility artefacts locally conserve signal all around their location in a symmetrical way, whereas background signal is suppressed by the applied gradient. In all experiments, a modified GE was created by varying the dephasing gradient strength with steps of 25%.

*Phantoms*

Small spherical fragments of Lead ($\chi_v$=-15.8ppm). Aluminum ($\chi_v$ =20.7ppm) Copper ($\chi_v$ - 9.63ppm) and plastic were embedded in agar gel ($\chi_v$ - 8.85 ppm) and imaged at 1.5 T with a conventional and modified GE sequence. Next, 21 excised rabbit livers were imaged. These rabbit livers were treated by internal radiation therapy with radioactive microspheres (20-50 $\mu$m), loaded with paramagnetic Holmium. Identical spheres were also imaged *in vivo* after administration of the paramagnetic particles to the liver of a living pig.

### Results

Usage of the modified GE sequence resulted in a selective and straightforward depiction of the local susceptibility transitions with positive contrast (Figure 13), even for the smallest susceptibility distortion. A similar observation was made for imaging of the paramagnetic microspheres in excised livers (Fig. 14). Here, comparison of detection by multi-echo GE and modified GE showed a high correlation between identification on both sequences for all 21 livers: clusters of microspheres could be depicted very well. Sources of susceptibility artifacts larger than voxel-dimensions, for instance air cavities or large vessels filled with microspheres, were partially visualized. Application of the modified sequence in vivo also resulted in a good depiction of the microspheres in the liver (Fig. 15), although the identification was little complicated by motion and sources of susceptibility like air-filled bowels.

**Discussion**

Application of the GE sequence with unbalanced selection gradients allowed easy, reliable, and selective detection of susceptibility artifacts in a straightforward way. The proposed technique is not hampered by any variation in background signal, which could obscure signal voids in the conventional way due to partial volume effects. Although the modification of the sequence was only small, it resulted in a selectively highlighting of the susceptibility artifacts. In case of thin slices, it can be necessary to use higher dephasing gradients to obtain the positive contrast, (Fig 13, 14). Because of the shape of the dipole field distortions and their spatial derivative, this higher gradient will not influence the detection of the particles and fragments, but their detected size will change according to the strength of the applied gradient. Because the identification by the modified GE sequence is based on local compensation of an applied gradient, those particles that are in the static dephasing regime [4], for instance the strong pertubers like the holmium microspheres, can be detected with the proposed technique

**References**

[1] Dumoulin CL, Souza SP, Darrow RD. Real-time position monitoring of invasive devices using magnetic resonance. Magn Reson Med 1993; 29(3):411-415.

[2] Konings MK, Bartels LW, Smits HF, Bakker CJ. Heating around intravascular guidewires by resonating RF waves. J Magn Reson Imaging 2000; 12(1):79-85.

[3] Bakker CJ, Hoogeveen RM, Weber J, van Vaals JJ, Viergever MA, Mali WP. Visualization of dedicated catheters using fast scanning techniques with potential for MR-guided vascular interventions. Magn Reson Med 1996; 36 (6):816-820.

[4] Yablonskiy DA, Haacke EM. Theory of NMR signal behavior in magnetically inhomogeneous tissues: the static dephasing regime. Magn Reson Med 1994; 32(6):749-763.

[5] Fazekas F, Kleinert R, Roob G, Kleinert G, Kapeller P, Schmidt R, Hartung H-P, Histopathologic analysis of foci of signal loss on Gradient-echo T2*Weighted MR images in patients with spontaneous intracerebral hemorrhage: evidende of microangiopathy-related microbleeds, Am J Neuroradiol 1999, 20(4):637-642

[6] Seppenwoolde JH, Bakker CJG, Viergever MA, Simulation of susceptibility artifacts to discriminate between different origins of focal hypo-intensities in MRI images, 2002, Proc 10th ISMRM scientific meeting and exhibition, Honolulu, Hawai'i, USA, p. 2324

**Claims**

1. Method for magnetic resonance imaging (MRI) of at least one specific element, wherein signal of background tissue represented in an MR image is at least partially dephased by applying a gradient imbalance or additional gradient, wherein signal around said element is accordingly conserved, resulting in a selective depiction of said element.

2. Method according to claim 1, wherein the background signal is suppressed by said gradient, especially said gradient imbalance.

3. Method according to claim 1 or 2, wherein additionally subtraction is applied.

4. Method according to any one of claims 1 - 3, wherein, diamagnetic, ferromagnetic paramagnetic elements are used.

5. Method according to any one of the previous claims, wherein an MRI is made of at least part of a human or animal body using an MRI-device, wherein said elements are foreign to said human or animal body.

**6.** Method according to any one of the previous claims, wherein said at least one element is part of device such as a surgical or diagnostic device.

**7.** Method for passive tracking of devices comprising at least one diamagnetic, paramagnetic or ferromagnetic element, wherein sequentially images are provided using MRI, wherein background signal of each MRI sequence is at least partially dephased with a slice gradient and signal near said elements is conserved.

**8.** Method according to claim 7, wherein at least a number of said images is superposed on an image comprising background features.

**9.** Method according to claim 8 or 9, wherein said at least one element is provided on a catheter or needle, introduced into a human or animal body.

**10.** Use of a dephasing signal in MR imaging (MRI), especially device tracking, for selective depiction with positive contrast of specific elements in images of said MRI.

**11.** Use according to claim 10, wherein each MR image is taken in less then 20 sec, especially less then 10 sec, more specifically less then 5 sec.

**12.** Method for enhancing contrast in an MR image on an imaging device, wherein an MRI signal is transferred to an imaging device, wherein said signal is dephased, such that a change in representation occurs of specific elements that create a magnetic dipole field inhomogeneity, resulting in a contrast enhanced representation of at least said element in said image.

**13.** MRI device, provided with means for performing a method or use according to any one of the previous claims.

**14.** MRI device according to claim 13, wherein said means comprises pulse sequentioning means for alternating between positive and negative contrast images, especially between white markers and black markers.

Fig. 1

Fig. 2

Fig. 3

A

$$\frac{\partial B_{z,inh}}{\partial x}(\mu T)$$

B

$$\frac{\partial B_{z,inh}}{\partial x}(\mu T)$$

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

**European Patent Office**

**EUROPEAN SEARCH REPORT**

Application Number

EP 03 07 6199

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | CH. J. BAKKER ET AL: "MR-guided endovascular interventions: susceptibility-based catheter and near-real-time imaging technique." RADIOLOGY, vol. 202, January 1997 (1997-01), pages 273-276, XP008023068 ISSN: 0033-8419 * the whole document * | 1-14 | G01R33/28 |
| X | CH. J. BAKKER ET AL: "Visualization of dedicated catheters using fast scanning techniques with potential for MR-guided vascular interventions" MAGNETIC RESONANCE IN MEDICINE, vol. 36, December 1996 (1996-12), pages 816-820, XP000636871 ISSN: 0740-3194 * the whole document * | 1-14 | |
| X | R. A. OMARY ET AL: "Real-time MR imaging-guided passive catheter tracking with use of gadolinium-filled catheters." JOURNAL OF VASCULAR AND INTERVENTIONAL RADIOLOGY, vol. 11, September 2000 (2000-09), pages 1079-1085, XP008023070 ISSN: 1051-0443 * pages 1079 - 1083: "Introduction" - "Results" * | 1-14 | **TECHNICAL FIELDS SEARCHED (Int.Cl.7)** G01R |

-/--

The present search report has been drawn up for all claims

| Place of search | Date of completion of the search | Examiner |
|---|---|---|
| THE HAGUE | 8 October 2003 | Volmer, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

Application Number

EP 03 07 6199

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | O. UNAL ET AL: "A RAPID 2D TIME-RESOLVED VARIABLE-RATE K-SPACE SAMPLING MR TECHNIQUE FOR PASSIVE CATHETER TRACKING DURING ENDOVASCULAR PROCEDURES" MAGNETIC RESONANCE IN MEDICINE, vol. 40, 1 September 1998 (1998-09-01), pages 356-362, XP000785531 ISSN: 0740-3194 * the whole document * --- | 1-14 | |
| X | R.M. HOOGEVEEN ET AL: "MR digital subtraction angiography with asymmetric echo acquisition and complex subtraction: improved lumen and stenosis visualization." MAGNETIC RESONANCE IMAGING, vol. 17, February 1999 (1999-02), pages 305-311, XP002256920 ISSN: 0730-725X | 1-6 | |
| A | * the whole document * --- | 7-14 | TECHNICAL FIELDS SEARCHED (Int.Cl.7) |
| X | R.G. MALES ET AL: "Clinical application of BASING and spectral/spatial water and lipid suppression pulses for prostate cancer staging and localization by in vivo 3D 1H magnetic resonance spectroscopic imaging." MAGNETIC RESONANCE IN MEDICINE, vol. 43, January 2000 (2000-01), pages 17-22, XP002256921 ISSN: 0740-3194 | 1-6 | |
| A | * the whole document * --- -/-- | 7-14 | |

The present search report has been drawn up for all claims

| Place of search | Date of completion of the search | Examiner |
|---|---|---|
| THE HAGUE | 8 October 2003 | Volmer, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 03 07 6199

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | J. MAO ET AL: "Fat tissue and fat suppression." MAGNETIC RESONANCE IMAGING, vol. 11, 1993, pages 385-393, XP008023067 ISSN: 0730-725X | 1-6 | |
| A | page385: abstract * the whole document * | 7-14 | |

TECHNICAL FIELDS SEARCHED (Int.Cl.7)

The present search report has been drawn up for all claims

| Place of search | Date of completion of the search | Examiner |
|---|---|---|
| THE HAGUE | 8 October 2003 | Volmer, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)